# EUROPEAN PATENT APPLICATION

(11) **EP 1 667 058 A1**
(43) Date of publication of application: **07.06.2006**
(21) Application number: 04027117.3
(22) Date of filing: 15.11.2004
(51) Int. Cl.: G06K 19/077

(54) **Package structure of memory card and packaging method for the structure**

(71) Applicant: SOLID STATE SYSTEM CO., LTD., Jubei City, Hsinchu, Taiwan 302 (CN)
(72) Inventor: Liou, Jhyy-Cheng, Jhubei City, Hsinchu County 302 (TW); Yang, Cheng-Yi, Hsinchu City 300 (TW); Hu, Ting-Chung, Wunshan District, Taipei City 116 (TW)
(74) Representative: Arth, Hans-Lothar

(57) **Abstract**

A package structure of a memory card includes a substrate. The substrate has connection pads (202) on a first surface and conductive lead structures (206) respectively coupled with the connection pads and extending to a second surface of the substrate. At least one chip (210) is disposed over the substrate at the first surface. A plurality of bonding structures (214) is respectively coupled between the conductive lead structures and the connection pads. A first packaging material layer (208) with a desired thickness is formed on the substrate, wherein the first packaging material layer has an opening region not cover the chip and the bonding structures. A second packaging material layer (216) with the same thickness as that of the first packaging material layer fills the opening region of the first packaging material layer. A packaging method for the memory card is also provided.

## Description

### BACKGROUND OF THE INVENTION

### Field of Invention

The present invention relates to memory card. More particularly, the present invention relates to the packaging structure of memory card and a packaging method for the memory card, which includes for example, multimedia card.

### Description of Related Art

Due to the great development of electronic circuit design, fabrication technology, and information science, the communication information can be digitalized, so that the communication information or other information can be easily stored in a semiconductor memory device and can be displayed or operated at, for example, a computer system or any displaying terminal. In the current market, the memory device includes many different type of products, and the multimedia card is one of memory devices having widely application, due to its small size. For example, the multimedia card is adapted into the digital camera for store the image information.

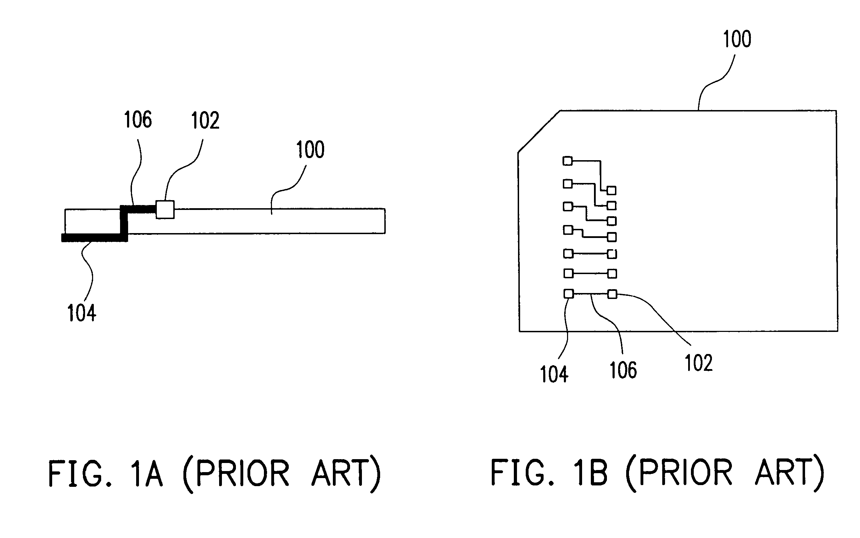

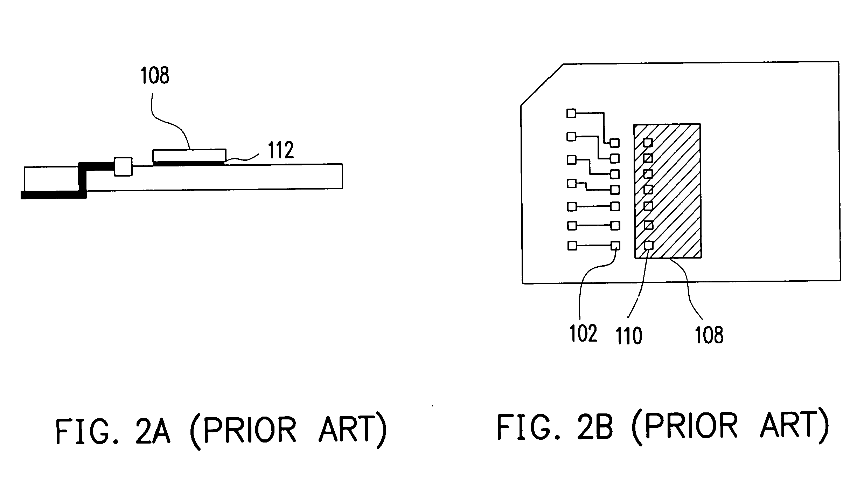

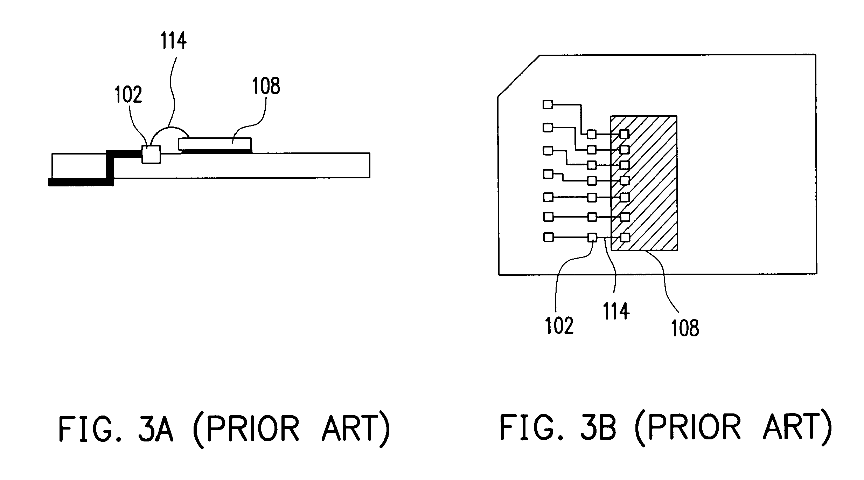

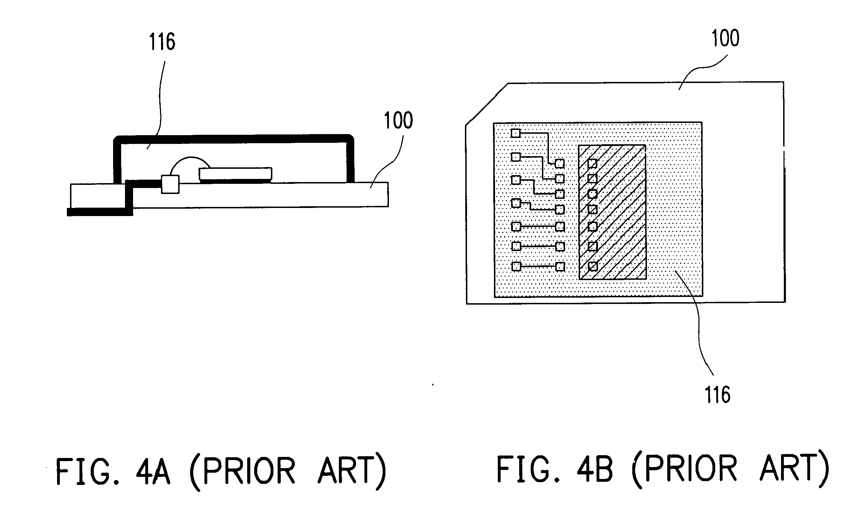

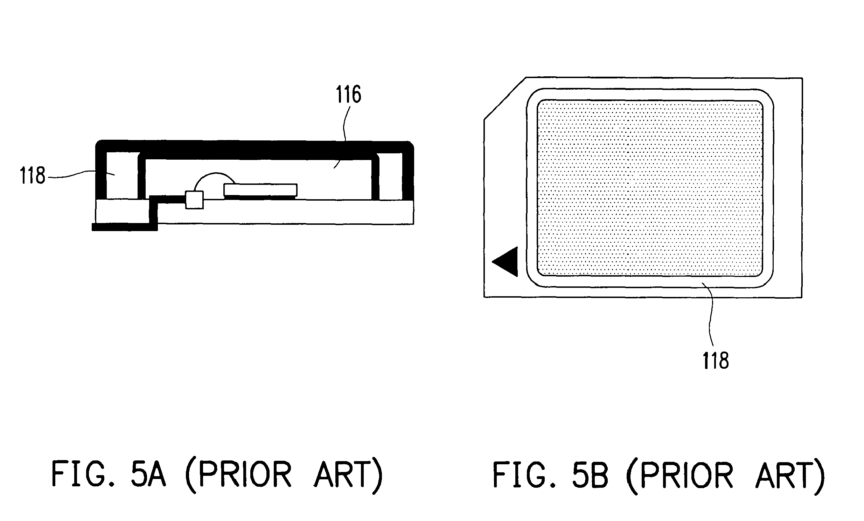

Usually, when the memory chip has been formed, the memory chip is necessary to be packaged to a board, so as to be insert into a multimedia apparatus in use. FIGs. 1A-5A are cross-sectional views, schematically illustrating processes of the conventional method to package the multimedia. FIGs. 1B-5B are top views, schematically illustrating processes of the conventional method to package the multimedia corresponding to FIGs. 1A-5A.

In FIG. 1A and FIG. 1B, a substrate 100 is provided to serve as a circuit board of the multimedia card. Several connection pads 102, 104 and the connection structure 106 are formed on the substrate 100. The pads 102 and the pads 104 are respectively disposed on two surfaces of the substrate 100. This is because the pads 102 are to be coupled with the memory chip and then be sealed as can be seen later.

In FIG. 2A and FIG. 2B, an adhesive layer 112 is formed on the substrate 100, and then a chip 108 is formed on the adhesive layer 112. The chip 108 has several I/O pads 110.

In FIG. 3A and 3B, a bonding process is performed to connect the pads 102 and the pad 110 via the bonding wire 114 or any connection structure in the state-of-the art.

In FIG. 4A and 4B, a packaging material layer 116 is formed, for example by molding, over the chip 108 and the connection structure to seal the whole structure, so that the chip and the connection structure is protected by the packaging material layer 116.

In FIG. 5A and FIG. 5B, a heat adhesive material layer 118 is formed over the whole area of the substrate 100 to get the multimedia card. Further, the multimedia card may further be printed with text or pasted by the label.

In this conventional structure of the multimedia card, the structure is not robust and easily to be broken by twisting or external stress. This is because the packaging structure includes the material layer 116 and the material layer 118, which are not firmly adhered to each other. The novel structure or fabrication method for packaging the multimedia card is still in need.

### SUMMARY OF THE INVENTION

The invention provides a package structure of a multimedia card, which has the robust structure to effectively reduce the damage on the memory card, such as multimedia card.

The invention provides a package method for packaging a memory card, which has the robust structure to effectively reduce the damage on the memory card.

The invention provides a package structure of a memory card, which comprises a substrate. The substrate has connection pads on a first surface and conductive lead structures respectively coupled with the connection pads and extending to a second surface of the substrate. At least one chip, or at least one multiple-stacked chip is disposed over the substrate at the first surface. A plurality of bonding structures is respectively coupled between the conductive lead structures and the connection pads. A first packaging material layer with a desired thickness is formed on the substrate, wherein the first packaging material layer has an opening region not cover the chip and the bonding structures. A second packaging material layer with the same thickness as that of the first packaging material layer fills the opening region of the first packaging material layer. A packaging method for the memory card is also provided.

In more general, the invention provides a package structure of a memory card, which comprises a substrate, having a plurality of connection pads on a first surface and a plurality of conductive lead structures respectively coupled with the connection pads and extending to a second surface of the substrate. At least one chip is disposed over the substrate at the first surface, wherein the chip has input/output pads being electrically coupled to the connection pads. A first packaging material layer is formed on the first surface of the substrate, wherein the first packaging material layer has an opening region to at least expose the chip. A second packaging material layer fills the opening region of the first packaging material layer.

In another aspect of the invention for the foregoing memory card, the first package material layer and the second package material have the same thickness.

In another aspect of the invention for the foregoing memory card, the first package material layer and the second package material can be the same material.

The invention also provides a packaging method for a memory card, comprising providing a substrate, having a plurality of connection pads on a first surface and a plurality of conductive lead structures respectively coupled with the connection pads and extending to a second surface of the substrate. A first packaging material layer is formed over the substrate, wherein the first packaging material layer has an opening region also exposing the connection pads. A memory chip is formed over the substrate within the opening region. Input/output pads of the chip are electrically bonded to the connection pads. The opening region is filled by a second packaging material layer.

In an aspect of the invention for the foregoing memory card, the first package material layer and the second package material layer have the same thickness.

In further another embodiment of the invention, the invention provides a packaging method for a memory card, comprising providing a substrate, having a plurality of connection pads on a first surface and a plurality of conductive lead structures respectively coupled with the connection pads and extending to a second surface of the substrate. A memory chip is disposed over the substrate within the opening region. The input/output pads of the chip are electrically bonded to the connection pads. A packaging material layer is formed over the substrate to serve as a protection layer, wherein the packaging material layer has a thickness satisfying a requirement of the memory card.

It is to be understood that both the foregoing general description and the following detailed description are exemplary, and are intended to provide further explanation of the invention as claimed.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

FIGs. 1A-5A are cross-sectional views, schematically illustrating processes of the conventional method to package the memory card.

FIGs. 1B-5B are top views, schematically illustrating processes of the conventional method to package the memory card corresponding to FIGs. 1A-5A.

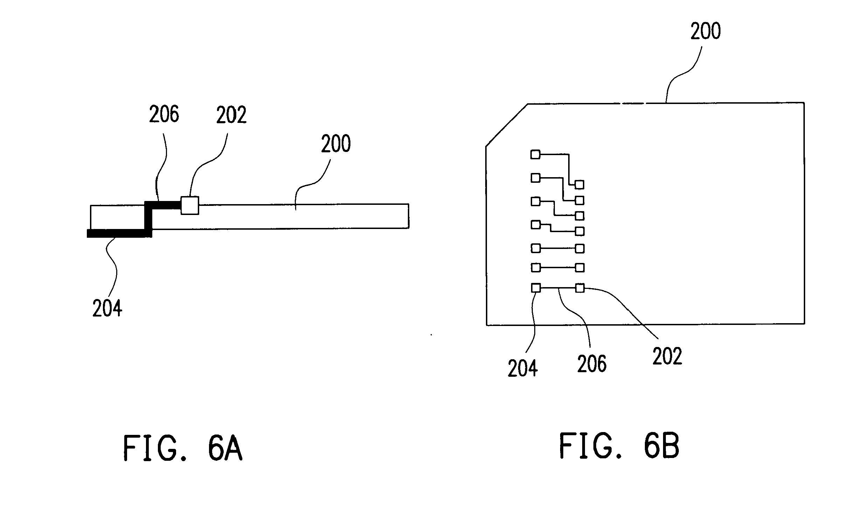

FIGs. 6A-9A are cross-sectional views, schematically illustrating processes of the method to package the memory card, according to a preferred embodiment of the invention.

FIGs. 6B-9B are top views, schematically illustrating processes of the method to package the memory card with respect to FIGs. 6A-9A, according to the preferred embodiment of the invention.

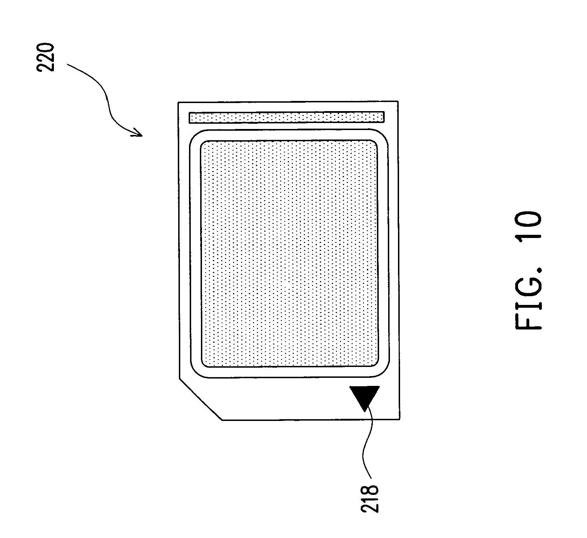

FIG. 10 is a top view, schematically illustrating a memory card, according to the preferred embodiment of the invention.

### DESCRIPTION OF THE PREFERRED EMBODIMENTS

In the invention, a novel packaging structure and a packaging method for a memory card are proposed. In the invention, the robust properties of the memory card can at least be effectively improved.

FIGs. 6A-9A are cross-sectional views, schematically illustrating processes of the method to package the memory card, according to a preferred embodiment of the invention. FIGs. 6B-9B are top views, schematically illustrating processes of the method to package the memory card, according to a preferred embodiment of the invention. The memory card includes, for example, multimedia card or any similar memory card for storing information. However, a multimedia card is preferred but the invention is not only limited to a multimedia card.

In FIG 6A and FIG 6B, a substrate 200 is provided to serve as a circuit board of the memory card. Several connection pads 202, 204 and the connection structure 206, such as conductive lead structure, are formed on the substrate 200. The pads 202 and the pads 204 are respectively disposed on two surface of the substrate 200. This is because the pads 202 are to be coupled with the memory chip and then be sealed as can be seen later.

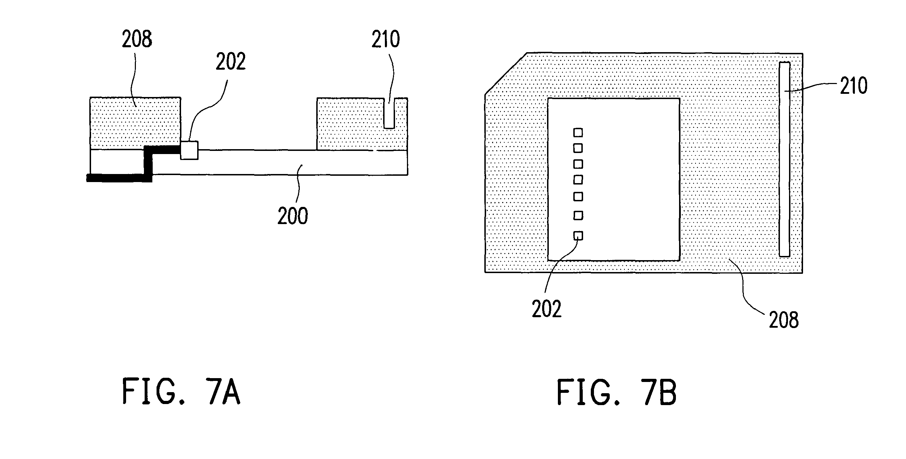

In FIG 7A and FIG. 7B, a packaging material layer 208 is formed on the same surface of the substrate having the pad 202. The packaging material layer 208 has an opening region to expose a region of the substrate, where a chip is to be disposed on. Here, the pads 202 are also exposed. Also and, a groove 210 can also be formed in the packaging material layer 208 at the edge of the ejection side of the memory card. The groove 210 is helpful for the pulling the memory card out from an electronic apparatus (not shown).

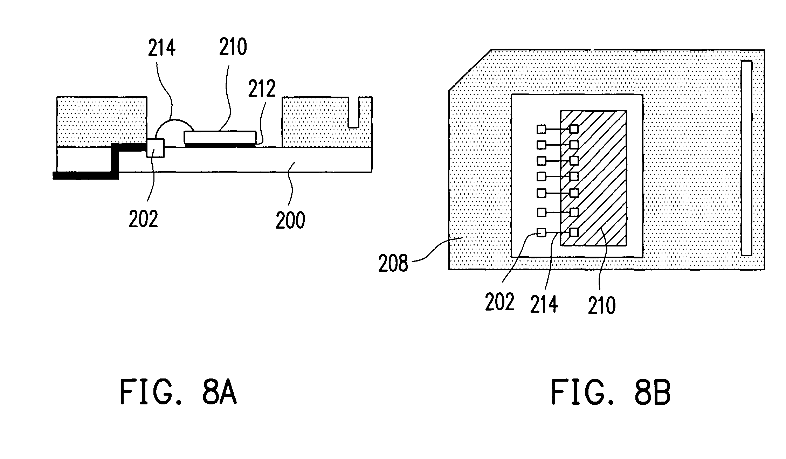

In FIG. 8A and FIG. 8B, at least one memory chip 210 is disposed onto the substrate 200 within the opening region. Here, one chip 210 is illustrated as the example for descriptions. The chip 210 can be for example adhered to the substrate 200 by, for example, an adhesive material layer 212. Then, a bonding process can be performed to form the bonding structure 214 for electrically connecting the input/output pads to the connection pads 202 by, for example, bonding wire 214. The packaging material layer 208 can, for example, has a thickness satisfying the requirement of a memory card.

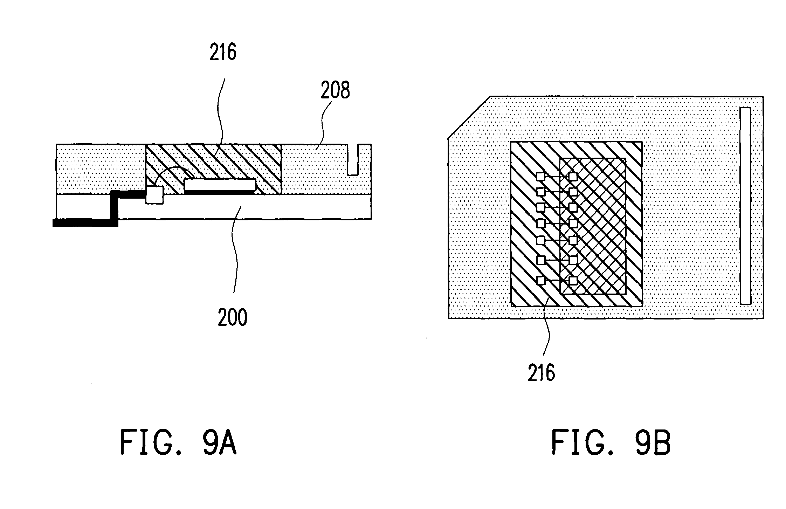

In FIG. 9A and FIG 9B, another packaging material layer 216 can be filled into the opening region to serve as a protection layer. After filling the packaging material layer 216 into the opening region, a planarization process can, for example, performed to have the same thickness as the thickness of the packaging material layer 208. FIG 10 is a top view, schematically illustrating a memory card, according to the preferred embodiment of the invention. In FIG 10, after packaging is accomplished, a marking process may be performed to print or paste the marks on the package of the memory card. For example, the product type, memory size, or any information with respect to the memory card 220 can be printed on the one side or both sides of the card. The injection direction 218 may be also included. The groove 210 (see FIG 7B) is helpful for moving the card 220 for ejection. However, the groove 210 is a preferred option. The other design is a design choice. For example, a little protruding structure can also, for example, be used in replace the groove.

As a result in the foregoing descriptions, the packaging material layer 208 and the packaging material layer 216 are well formed together as a solid bulk. Or, for example, it can be the same material layer. The mechanical strength can be improved, and the damage due to twisting or external force can be effectively reduced.

From the fabrication method point of view, a substrate 200 is provided in FIG. 6A. The substrate 200 has a plurality of connection pads 202 on a first surface and a plurality of conductive lead structures 206+204 respectively coupled with the connection pads 202 and extending to a second surface of the substrate 200. A first packaging material layer 208 is formed over the substrate 200 in FIG 7A, wherein the first packaging material layer 208 has an opening region also exposing the connection pads 202. In FIG 8A, a memory chip 210 is formed over the substrate 200 within the opening region. Multiple input/output pads of the chip 210 are electrically coupled to the connection pads 202 via, for example, the bonding wire 214. The opening region is filled by a second packaging material layer 216 in FIG. 9A.

In the foregoing processes, the first packaging material layer 208 is formed with the opening region. Then, the chip 210 is adhered to the substrate 200. However, alternatively, the chip 210 can be first adhered to the substrate 200 before the packaging material layer is formed. In other words, the packaging material layer is formed over the substrate after the chip 210 is adhered to the substrate 200.

According to the invention, the memory card has the firm structure, which is well compact together. As a result, the memory can have better capability to resist the twisting or external force. Also and, the packaging material layer has the required thickness. This can simplify the fabrication process.

It will be apparent to those skilled in the art that various modifications and variations can be made to the structure of the present invention without departing from the scope or spirit of the invention. In view of the foregoing descriptions, it is intended that the present invention covers modifications and variations of this invention if they fall within the scope of the following claims and their equivalents.

## Claims

1. A package structure of a memory card, comprising:
a substrate, having a plurality of connection pads on a first surface and a plurality of conductive lead structures respectively coupled with the connection pads and extending to a second surface of the substrate;
at least one chip or at least one multiple-stacked chip, disposed over the substrate at the first surface;
a plurality of bonding structures, respectively coupled between the conductive lead structures and the connection pads;
a first packaging material layer with a desired thickness, formed on the first surface of the substrate, wherein the first packaging material layer has an opening region not cover the chip and the bonding structures; and
a second packaging material layer, filling the opening region of the first packaging material layer, with substantially the same thickness as that of the first packaging material layer.

2. The package structure of claim 1, wherein the first packaging material layer further comprises a groove at an ejection edge.

3. The package structure of claim 1, further comprising a printed text or a pasted label on a surface of the package structure.

4. The package structure of claim 1, wherein the chip is disposed over the substrate by an adhesive material layer.

5. The package structure of claim 1, wherein the first package material layer and the second package material layer have the same material.

6. A package structure of a memory card, comprising:
a substrate, having a plurality of connection pads on a first surface and a plurality of conductive lead structures respectively coupled with the connection pads and extending to a second surface of the substrate;
at least one chip or at least one multiple-stacked chip, disposed over the substrate at the first surface, wherein the chip has input/output pads being electrically coupled to the connection pads;
a first packaging material layer, formed on the first surface of the substrate, wherein the first packaging material layer has an opening region to at least expose the chip; and
a second packaging material layer, filling the opening region of the first packaging material layer.

7. The package structure of claim 6, further comprising a printed text or a pasted label on a surface of the package structure.

8. The package structure of claim 6, wherein the chips is disposed over the substrate by an adhesive material layer.

9. The package structure of claim 6, wherein the first packaging material layer has a groove at an ejection side of the memory card.

10. The package structure of claim 6, wherein the chip is disposed on the substrate by an adhesive material layer.

11. The package structure of claim 6, wherein the first packaging material layer and the second material layer have substantially equal thickness.

12. The package structure of claim 6, wherein the first package material layer and the second package material layer have the same material.

13. A packaging method for a memory card, comprising:
providing a substrate, having a plurality of connection pads on a first surface and a plurality of conductive lead structures respectively coupled with the connection pads and extending to a second surface of the substrate;
forming a first packaging material layer over the substrate, wherein the first packaging material layer has an opening region also exposing the connection pads;
forming a memory chip over the substrate within the opening region;
electrically bonding input/output pads of the chip to the connection pads; and
filling the opening region by a second packaging material layer.

14. The packaging method of claim 13, further comprising performing a marking process to mark the memory card.

15. The packaging method of claim 13, wherein the first packaging material layer and the second material layer have substantially equal thickness.

16. The packaging method of claim 13, wherein the step of forming the chip is by an adhering material.

17. The packaging method of claim 13, wherein the step of filling the opening region by the second packaging material layer further comprises a planarization process to have the first packaging material layer and the second material layer being in substantially equal thickness.

18. The packaging method of claim 13, wherein a thickness of the first packaging material layer has a desired thickness satisfying the requirement of the memory card.

19. A packaging method for a memory card, comprising:
providing a substrate, having a plurality of connection pads on a first surface and a plurality of conductive lead structures respectively coupled with the connection pads and extending to a second surface of the substrate;
forming a memory chip over the substrate within an opening region;
electrically bonding input/output pads of the chip to the connection pads; and
forming a packaging material layer over the substrate to serve as a protection layer, wherein the packaging material layer has a thickness satisfying a requirement of the memory card.

20. The packaging method of claim 19, further comprising forming a groove on the packaging material layer at an ejection side of the memory card.
